# EUROPÄISCHE PATENTANMELDUNG

(11) **EP 1 314 993 A2**
(43) Veröffentlichungstag der Anmeldung: **28.05.2003**
(21) Anmeldenummer: 02023102.3
(22) Anmeldetag: 15.10.2002
(51) Int. Cl.: G01R 33/02

(54) **Vorrichtung zur Messung eines Magnetfeldes und Strommessvorrichtung**

(30) Priorität: 23.11.2001 DE 10157509
(71) Anmelder: ROBERT BOSCH GMBH, 70442 Stuttgart (DE)
(72) Erfinder: Hauenstein, Henning, 72762 Reutlingen (DE); Ernst, Stephan, 73760 Ostfildern (DE)

(57) **Zusammenfassung**

Es wird eine Vorrichtung zur Messung eines Magnetfeldes (22) und eine Strommessvorrichtung vorgeschlagen, wobei ein Mittel zur Sensierung eines Magnetfeldes, ein Mittel zur Erzeugung eines einstellbaren Kompensationsmagnetfeldes auf einem Substrat (10) monolithisch integriert vorgesehen sind.

## Beschreibung

### Stand der Technik

Für eine berührungslose, verlustarme und potenzialgetrennte Messung eines elektrischen Stromes eignet sich insbesondere die Messung des durch den Strom erzeugten Magnetfeldes, wofür sich Sensorelemente, wie beispielsweise Hallsensoren, magnetoresistive Widerstände oder Magnetotransistoren eignen. In vielen Anwendungen wird eine sehr genaue Strommessung über mehrere Größenordnungen hinweg und eine möglichst geringe Störanfälligkeit gefordert, wobei der Einsatzort der benötigten, hochempfindlichen Strom- beziehungsweise Magnetfeldsensoren im allgemeinen stark elektromagnetisch belastet ist, insbesondere durch Streufelder und Störfelder von benachbarten Stromleitern oder beispielsweise durch rotierende Magnetfelder in der Umgebung eines Generators. Daher ist die Diskriminierung zwischen dem zu messenden Magnetfeld und den parasitären Streufeldern der Umgebung sehr schwer, da selbst bei hohen Strömen von einigen Hundert Ampere die Magnetfelder, die den Leiter umgeben, oft nur in der Größenordnung von wenigen Millitesla liegen. Die Feldstärke der zu messenden Magnetfelder ist damit häufig nur unwesentlich höher als die Feldstärke der parasitären Streufelder.

Es sind allgemein empfindliche und gut gegen solche parasitären Störungen abgeschirmte Magnetfeldsensoren bekannt, wobei häufig zusätzlich das Magnetfeld durch einen sogenannten Magnetkreis konzentriert wird - beispielsweise in Form eines Flusskonzentrators - , so dass das Magnetfeld für die Messung verstärkt wird. Zusätzliche bekannte Maßnahmen umfassen eine geeignete Beschaltung der Sensoren - beispielsweise in Form von ASICs oder als diskrete Schaltkreise - , wodurch eine möglichst hohe Empfindlichkeit der Messung realisiert wird. Allgemein bekannt ist ebenfalls, das zu messende Magnetfeld nicht direkt zu registrieren, sondern durch die Erzeugung eines Gegenfeldes am Ort des Sensors zu eliminieren. Aus der Kenntnis des benötigten Gegenfeldes, welches beispielsweise durch eine Spule erzeugt werden kann, schließt man dann auf das zu messende Magnetfeld zurück. Vorteil dieser bekannten Kompensationsmethode ist, dass man das Magnetfeld sehr genau auf Null abgleichen kann, wenn man einen sehr sensitiven Sensor verwendet. Dieser Sensor muss lediglich den Nullabgleich des Magnetfeldes messen. Selbst bei sehr hohen, zu messenden Magnetfeldern wird der Sensor nicht in Sättigung gehen, da er stets nur das kompensierte Magnetfeld, das heißt die resultierende aus dem zu messenden Magnetfeld und des Gegenfeldes, zu registrieren hat. Nachteilig bei den bekannten Kompensationsmethoden ist, dass diese im allgemeinen eine eigene, aufwendige Beschaltung und zusätzlichen Bauraum für den das Kompensationsfeld erzeugenden Magnetfeldgenerator benötigen.

### Vorteile der Erfindung

Die erfindungsgemäße Vorrichtung zur Messung eines Magnetfeldes und die erfindungsgemäße Strommessvorrichtung gemäß den Merkmalen der nebengeordneten Ansprüche haben demgegenüber den Vorteil, dass sowohl die Sensorik als auch die Erzeugung des Gegenfeldes auf einem einzigen Substrat integriert sind. Dadurch ergibt es sich, dass sich mit einer erfindungsgemäßen Kompensationsmethode mit einem einzigen, hochempfindlichen Sensor sehr große Messbereiche abdecken lassen, da die eigentliche Magnetfeldmessung aus dem erzeugten Gegenfeld resultiert. Weiterhin ist es vorteilhaft, die bisher bekannten externen oder schaltungstechnischen Kompensationsmethoden durch eine On-chip-Lösung zu ersetzen. Weiterhin ist von Vorteil, dass der erfindungsgemäße Magnetfeldsensor, der Magnetfeldgenerator für das Kompensationsfeld und die Ansteuer- und Auswerte-Logik auf einem einzigen Chip integriert sind. Der den zu messenden Strom tragenden Leistungsteil - das heißt der Leiterabschnitt, durch den der zu messende Strom fließt - kann ebenfalls vorteilhaft auf dem Chip integriert werden. Hieraus ergibt sich für die Herstellung des Sensors, der Intelligenz - das heißt der Auswerte- und Steuer-Logik - und des Magnetfeldgenerators auf einem einzigen Chip der Vorteil, dass die Herstellung kostengünstig und platzsparend zu bewerkstelligen ist. Weiterhin macht eine On-chip-Kompensationsmethode den externen Schaltungsaufwand und zusätzliche Komponenten überflüssig, die bei Kompensationsmethoden gemäß dem Stand der Technik bisher notwendig sind. Weiterhin reduziert sich auch der Montageaufwand gegenüber bisherigen Kompensationslösungen. Der Bauraum für den Sensor und den Magnetfeldgenerator reduziert sich ebenfalls auf den einzigen integrierten Chip, welcher lediglich in die Applikation zu integrieren ist. Aufgrund der Integration ist es weiterhin möglich, externe Stör- und Streufelder aufgrund der kompakten Bauform gut abzuschirmen. Weiterhin ist es für die Herstellung möglich, sämtliche Komponenten, das heißt den Leistungsteil, den Sensor, die Ansteuerungs- und Auswerte-Logik, kostengünstig in einem einzigen Prozess herzustellen.

### Zeichnung

Ausführungsbeispiele der Erfindung sind in der Zeichnung dargestellt und werden in der nachfolgenden Beschreibung näher erläutert. Es zeigen
Figur 1 eine schematische Skizze einer ersten Ausführungsform der erfindungsgemäßen Vorrichtung,
Figur 2 eine zweite Ausführungsform der erfindungsgemäßen Vorrichtung und
Figur 3 eine Darstellung des Funktionsprinzips der erfindungsgemäßen Vorrichtung.

### Beschreibung der Ausführungsbeispiele

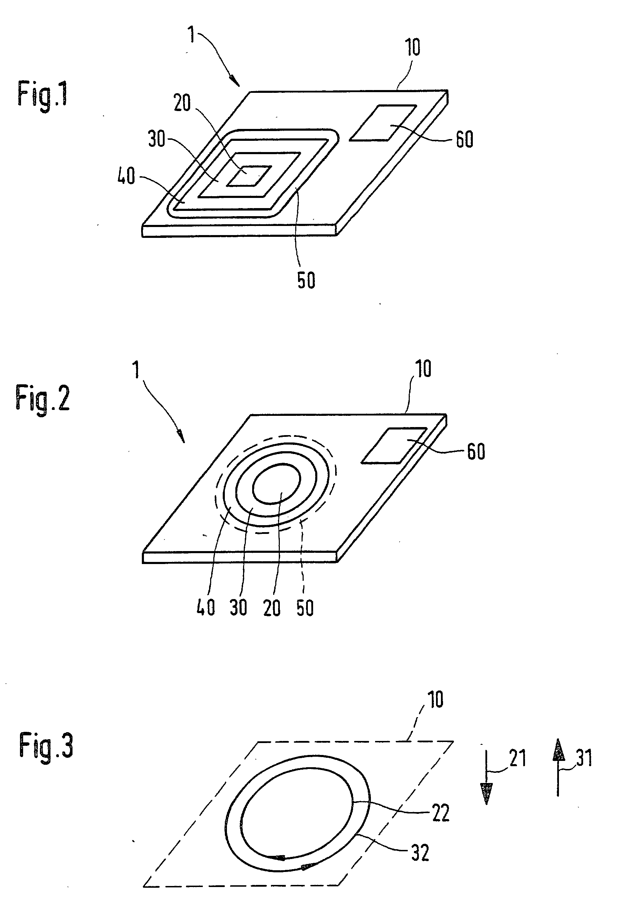

In Figur 1 ist eine schematische Skizze eines ersten Ausführungsbeispiels einer erfindungsgemäßen Vorrichtung 1 dargestellt. Die erfindungsgemäße Vorrichtung 1 umfasst auf einem Substrat 10 einen Bereich 50 und eine Auswerte- und Ansteuerungsschaltung 60, welche in einem weiteren Bereich des Substrates 10 vorgesehen ist. Das Substrat 10 ist erfindungsgemäß insbesondere als Halbleitersubstrat, insbesondere als Siliziumsubstrat, vorgesehen. Der Bereich 50 des Substrates 10 umfasst erfindungsgemäß insbesondere einen ersten Teilbereich 20, einen zweiten Teilbereich 30 und einen dritten Teilbereich 40. Der erste Teilbereich 20 ist erfindungsgemäß insbesondere als Teilabschnitt eines stromtragenden Leiters ausgebildet, welcher einen Strom trägt, der im Bereich 50 vertikal durch das Substrat 10 fließt. Hierdurch ergibt sich ein Magnetfeld in der Substratebene, welches durch den im ersten Teilbereich 20 senkrecht durch das Substrat hindurchfließenden Strom hervorgerufen wird. Der zweite Teilbereich 30 umfasst den Magnetfeldgenerator, das heißt, eine Anordnung, die einen vertikal durch das Substrat 10 fließenden Strom generiert, so dass ein Magnetfeld entsteht, welches dem von dem durch den ersten Teilbereich 20 fließenden Strom erzeugten Magnetfeld entgegengesetzt ist. Im dritten Teilbereich 40 umfasst der Bereich 50 des Substrates 10 eine Anordnung zum Sensieren eines Magnetfeldes, wobei die Anordnung zum Sensieren eines Magnetfeldes das resultierende Magnetfeld aus dem im ersten Teilbereich 20 und im zweiten Teilbereich 30 fließenden Strom sensiert. In Figur 1 sind keine Verbindungsleitungen zwischen der Auswerteschaltung 60 und dem Bereich 50 des Halbleitersubstrates 10 dargestellt. Diese sind jedoch selbstverständlich vorhanden, um eine Steuerungsmöglichkeit und Auswertemöglichkeit zu schaffen. Weiterhin sind auch Anschlüsse von dem Substrat 10 zu der externen Umgebung des Substrates 10 in Figur 1 nicht dargestellt.

In Figur 2 ist eine schematische Skizze eines zweiten Ausführungsbeispiels der erfindungsgemäßen Vorrichtung 1 dargestellt. Dargestellt ist wiederum das Substrat 10, die Auswerte-Logik 60, sowie der Bereich 50 des Substrates 10, welche den ersten Teilbereich 20, den zweiten Teilbereich 30 und den dritten Teilbereich 40 umfasst. Auch in Figur 2 sind die Verbindungsleitungen sowohl zwischen der Auswerte-Logik 60 und dem Bereich 50 als auch nach extern nicht dargestellt. Im Gegensatz zum in Figur 1 dargestellten ersten Ausführungsbeispiel ist das in Figur 2 dargestellte zweite Ausführungsbeispiel derart vorgesehen, dass der Bereich 50 insbesondere im wesentlichen eine runde Form aufweist, wobei auch die Teilbereiche 20, 30, 40 eine im wesentlichen runde Form aufweisen. Bei der Figur 1 ist der Bereich 50 und seine Teilbereiche 20, 30, 40 im wesentlichen durch eine rechtekkige beziehungsweise insbesondere quadratische Form dargestellt.

In Figur 3 ist eine Prinzipskizze des Funktionsprinzipes der erfindungsgemäßen Vorrichtung dargestellt. Es wird angenommen, dass im ersten Teilbereich 20, der in Figur 3 nicht dargestellt ist, ein erster vertikaler Stromfluss vorherrscht, welcher in Figur 3 durch einen mit dem Bezugszeichen 21 versehenen Pfeil dargestellt ist. Der erste Strom 21 produziert in der gestrichelt dargestellten und ebenfalls mit dem Bezugszeichen 10 versehenen Substratebene ein durch einen ringförmigen und mit dem Bezugszeichen 22 versehenen Pfeil dargestelltes erstes Magnetfeld. Das erste Magnetfeld 22 wird auch als das zu messende Magnetfeld 22 bezeichnet. Im zweiten Teilbereich 30 herrscht bei der erfindungsgemäßen Vorrichtung ein zweiter Stromfluss vor, welcher in der Figur 3 durch einen mit dem Bezugszeichen 31 versehenen Pfeil dargestellt ist. Der zweite Teilbereich 30 ist in der Figur 3 ebenfalls nicht dargestellt. Der zweite Strom 31 produziert in der Substratebene 10 ein zweites Magnetfeld 32, welches durch einen ringförmigen und mit dem Bezugszeichen 32 versehenen Pfeil dargestellt ist, welches gegenüber dem ersten Magnetfeld 22 gegenläufig orientiert ist. Das zweite Magnetfeld 32 wird insbesondere auch als Kompensationsfeld 32 oder Gegenfeld 32 bezeichnet. Die im dritten Teilbereich 40 angeordneten Magnetfeldsensoren registrieren im wesentlichen nur, das aus dem ersten Magnetfeld 22 und dem zweiten Magnetfeld 32 resultierende Magnetfeld, welches in Figur 3 nicht eigens durch ein Bezugszeichen dargestellt ist.

Das Prinzip der Erfindung beruht darauf, dass ein vertikaler Stromfluss, das heißt der erste Strom 21, durch einen Leiter oder einen Halbleiterchip - das heißt in der Figur 1 und 2 insbesondere im ersten Teilbereich 20 angeordnet - ein ringförmiges, den Leiter beziehungsweise den Chip umgebendes Magnetfeld - erstes Magnetfeld 22 -erzeugt. Es ist daher vorteilhaft, einen stromtragenden Leiter beziehungsweise Halbleiter im Zentrum eines Halbleiterchips beziehungsweise des Bereiches 50 zu platzieren. Dies ist in Figur 1 und 2 auch dargestellt, da sich der erste Teilbereich 20 jeweils im wesentlichen im Zentrum des Bereiches 50 befindet. Der im ersten Teilbereich 20 befindliche Leiter ist erfindungsgemäß insbesondere als Leistungstransistor, beispielsweise als Power-MOS, Bipolartransistor, etc. vorgesehen, dessen Zellen sich im ersten Teilbereich 20 befinden. Wird dieser Leistungsteil des Chips mit magnetfeldsensitiven Elementen, beispielsweise magnetfeldsensierenden Zellen - die beispielsweise auf der Nutzung des Halleffekts, des magnetoresistiven Effekts, des Magnetotransistoreffekts etc. beruhen - , so kann man mit dieser magnetfeldsensitiven Zellstruktur das erste Magnetfeld 22 messen, welches den im ersten Teilbereich 20 befindlichen Leistungsteil radial umgibt. Hierdurch ist es möglich, das erste Magnetfeld 22 direkt zu messen. Das Umgeben des ersten Teilbereiches 20 mit magnetfeldsensitiven Elementen ist in Figur 1 und 2 dadurch dargestellt, dass der dritte Teilbereich 40 insbesondere auch den ersten Teilbereich 20 umgibt. Um jedoch mit hochempfindlichen Sensoren einen sehr großen Messbereich abzudecken, ist es vorteilhaft, eine Kompensationsmethode zu verwenden, mit der das zu messende Magnetfeld 22 jeweils, insbesondere auf Null, abgeglichen wird. Zur Steigerung der Messempfindlichkeit und um einen möglichst großen Messbereich zu realisieren ist es daher vorteilhaft, eine weitere Zellstruktur zwischen dem im dritten Teilbereich 40 vorgesehenen Magnetfeld sensierenden Zellen und dem im ersten Teilbereich 20 vorgesehenen eigentlichen stromtragenden Leistungsteil vorzusehen. Diese zwischen dem Sensorteil - im dritten Teilbereich 40 - und dem Leistungsteil - im ersten Teilbereich 20 - liegende Zellstruktur hat die Aufgabe, ein Kompensationsmagnetfeld 32 zu erzeugen. Vorteilhaft kann dies beispielsweise durch Zellen erfolgen, die einen regelbaren, vertikalen Stromfluss - der Strom 31 zur Erzeugung des Gegenfeldes - erzeugen, beispielsweise mittels eines Leistungstransistors beziehungsweise mittels Power-MOS-Zellen. Beispielsweise kann in einem BCD-Prozess durch vergrabene Strukturen ein entsprechender vertikaler Stromfluss 31 mit entgegengesetzt zum zentralen Hauptstrom 21 liegender Richtung realisiert werden.

Der Stromfluss (zweiter Strom 31) im zweiten Teilbereich 30 ist so zu wählen, dass am Ort der Sensorzellen im dritten Teilbereich 40 das erzeugte Kompensationsfeld 32 entgegengesetzt zu dem Feldverlauf des vom zentralen Leistungsteils im ersten Teilbereich 20 stammenden Magnetfeldes 22 gerichtet ist. Auf diese Weise erhält man im äußeren, magnetfeldsensitiven und im dritten Teilbereich 40 untergebrachten Chipbereich zwei gegenläufige Magnetfelder 22, 32. Durch geeignete Variation des Stromflusses in dem zweiten Teilbereich 30, das heißt in der mittleren Zellstruktur, kann man das Feld des Leistungsteiles, welches im ersten Teilbereich 20 vorgesehen ist, am Ort der Sensorzellen, das heißt im dritten Teilbereich 40, je nach Bedarf kompensieren. Bei Abwesenheit eines zweiten Stromes 31 messen die im dritten Teilbereich 40 untergebrachten Sensorzellen das ungestörte Feld 22 des im ersten Teilbereich 20 untergebrachten zentralen Leistungsteils.

Dies ermöglicht es, über einen sehr großen Messbereich hinweg, den Einsatz von hochempfindlichen Sensorzellen im dritten Teilbereich 40, die die Kompensation der Magnetfelder 22, 32 sehr genau ermöglichen und eine entsprechend hohe Messempfindlichkeit realisieren können. Aus der Kenntnis des Zusammenhangs zwischen dem erzeugten Kompensationsfeld 32 und dem zur Erzeugung des Kompensationsfeldes 32 benötigten zweiten Strom 31 kann die Größe des vom zentralen Leistungsteil im ersten Teilbereich 20 stammenden Magnetfeldes 22 ermittelt werden. Erfindungsgemäß ist es also vorgesehen, im zweiten Teilbereich 30 ein zweites Mittel vorzusehen, welches das Kompensationsfeld 32 erzeugt und welches erfindungsgemäß insbesondere als Leistungstransistor vorgesehen ist. Erfindungsgemäß ist daher insbesondere ein zweites Mittel vorgesehen, welches im dritten Teilbereich 40 untergebracht ist und magnetfeldsensitive Elemente umfasst, welche ein in der Ebene des Substrates 10 verlaufendes Magnetfeld sensieren, wobei das sensierte Magnetfeld entweder dem resultierenden Magnetfeld aus dem ersten Magnetfeld 22 und dem zweiten Magnetfeld 32 entspricht - wenn das zweite Magnetfeld 32 durch Einschalten des im zweiten Teilbereich 30 befindlichen Magnetfeldgenerators nicht verschwindet - oder wobei das resultierende Magnetfeld gleich dem ersten Magnetfeld 22 ist - wenn der im zweiten Teilbereich 30 befindliche Magnetfeldgenerator ausgeschaltet ist.
Durch periodisches Ein- und Ausschalten des Magnetfeldgenerators kann auch eine periodische Modulation des ersten Magnetfeldes 22 durch Überlagerung des variierenden Feldes 32 erfolgen, wodurch frequenzsensitive Messmethoden (z.B. Verwendung von Lock-In-technik oder anderer rauschunterdrückender Messmethoden) zur Messung des Magnetfeldes 22 eingesetzt werden können.

Erfindungsgemäß ist es insbesondere vorgesehen, die erfindungsgemäße Vorrichtung in einem einzigen Halbleiterprozess herzustellen.

Die beschriebene On-chip-Kompensationsmethode beziehungsweise die erfindungsgemäße Vorrichtung kann auch mehrfach auf einem Chip angewendet beziehungsweise wiederholt werden. Je nach Anwendung kann auch die stromtragende Struktur im ersten Teilbereich 20 ringförmig um die zentralliegende Kompensationsstromstruktur im zweiten Teilbereich 30 angeordnet werden. Dies bedeutet gegenüber den Figuren 1 und 2 eine Vertauschung des ersten Teilbereiches 20 und des zweiten Teilbereiches 30.

Die erfindungsgemäße Magnetfeldmessvorrichtung beziehungsweise Strommessvorrichtung ist vorteilhaft mit einer Ansteuer- und Auswerte-Logik auf dem Substrat 10 gemeinsam integriert.

Für die erfindungsgemäße Vorrichtung ist die Kombination von verschiedenen Funktionen, wie beispielsweise die Leistungstreiber, die Sensorik und die Intelligenz, notwendig, wofür insbesondere Mischprozesse, wie ein BCD-Prozess besonders vorteilhaft ist. Als Ausführungsformen der Erfindung sind generell alle Magnetfeldsensoren geeignet, die auf lateral zur Chipfläche des Substrates 10 verlaufende Felder empfindlich sind, insbesondere alle Elemente, die nach dem Hallprinzip arbeiten.

Die vollständige Umschließung der im dritten Teilbereich 40 vorgesehenen Sensorzellen der beiden anderen Teilbereiche 20, 30 macht es erfindungsgemäß möglich, im dritten Teilbereich 40 das Umlaufintegral des aus dem ersten Magnetfeld 22 und dem zweiten Magnetfeld 32 resultierenden Magnetfeldes zu bestimmen, wodurch direkt der resultierende Strom durch den geschlossenen Integrationspfad zugänglich ist. Erfindungsgemäß ist es sowohl vorgesehen, das Gegenfeld 32 durch den zweiten Strom 31 so zu wählen, dass das resultierende Feld auf Null abgeglichen ist; alternativ ist es aber auch möglich, das Gegenfeld 32 lediglich in diskreten Abständen regeln beziehungsweise einstellen zu können, so dass allgemein das resultierende Feld nicht verschwindet, sondern lediglich (wesentlich) kleiner als das zu messende Magnetfeld 22 ist. In diesem Fall würde auf das zu messende Magnetfeld in zwei Schritten geschlossen werden, nämlich einmal durch das zweite Magnetfeld 32 und zum anderen durch die Messung der Stärke des resultierenden Magnetfeldes. Bei einem Abgleich zu Null des resultierenden Magnetfeldes muss lediglich angeschaut werden, welches Gegenfeld 32 erforderlich ist.

## Patentansprüche

1. Vorrichtung (1) zur Messung eines Magnetfeldes (22), mit einem zweiten Mittel zur Sensierung des Magnetfeldes (22), mit einem ersten Mittel zur Erzeugung eines einstellbaren Kompensationsmagnetfeldes (32) am Ort (40) des zweiten Mittels, wobei zur Messung des Magnetfeldes (22) das Kompensationsmagnetfeld (32) derart eingestellt vorgesehen ist, dass vom zweiten Mittel ein, im Vergleich zur Stärke des Magnetfeldes (22) insbesondere kleines, resultierendes Magnetfeld sensiert wird, wobei das zweite Mittel und das erste Mittel auf einem Substrat (10) monolithisch integriert vorgesehen sind.

2. Vorrichtung nach Anspruch 1, **dadurch gekennzeichnet, dass** das Magnetfeld (22) von einem Stromfluss (21) durch einen Leiter erzeugt wird, wobei der Leiter einen Leiterabschnitt umfasst, wobei der Leiter auf dem Substrat (10) monolithisch integriert vorgesehen ist.

3. Vorrichtung nach Anspruch 1 oder 2, **dadurch gekennzeichnet, dass** der Leiter, das erste Mittel und das zweite Mittel in einem Bereich (50) des Substrates (10) vorgesehen ist, wobei der Leiter im Zentrum des Bereichs (50) vorgesehen ist, wobei das erste Mittel in der Substratebene den Leiter umschließend vorgesehen ist und wobei das zweite Mittel in der Substratebene das erste Mittel umschließend vorgesehen ist.

4. Vorrichtung nach Anspruch 2 oder 3, **dadurch gekennzeichnet, dass** der Leiter und das erste Mittel als Leistungstransistoren vorgesehen sind.

5. Vorrichtung nach einem der vorhergehenden Ansprüche, **dadurch gekennzeichnet, dass** das zweite Mittel als Magnetfeld sensitive Elemente vorgesehen ist, wobei die Magnetfeld sensitiven Elemente ein in der Ebene des Substrates (10) verlaufendes Magnetfeld sensieren.

6. Vorrichtung nach einem der vorhergehenden Ansprüche, **dadurch gekennzeichnet, dass** eine Auswerteschaltung (60) vorgesehen ist, wobei die Auswerteschaltung (60) auf dem Substrat (10) monolithisch integriert vorgesehen ist.

7. Strommessvorrichtung zur Messung der elektrischen Stromstärke eines elektrischen Stromes (21) in einem Leiter, wobei der Strom (21) ein Magnetfeld (22) hervorruft und wobei das Magnetfeld (22) mittels einer Vorrichtung nach einem der vorhergehenden Ansprüche messbar vorgesehen ist.
